# EUROPEAN PATENT SPECIFICATION

(11) **EP 3 327 772 B1**
(45) Date of publication and mention of the grant of the patent: **18.09.2019**
(21) Application number: 16306571.7
(22) Date of filing: 29.11.2016
(51) Int. Cl.: H01L 23/473, H01L 33/64

(54) **METHOD OF MANUFACTURING MICRO-/OPTO-ELECTRONIC DEVICES INCLUDING COOLING MEANS**
HERSTELLUNGSVERFAHREN FÜR MIKRO-/OPTOELEKTRONISCHE VORRICHTUNGEN MIT KÜHLMITTELN
MÉTHODE DE FABRICATION DE DISPOSITIFS MICRO/OPTOÉLECTRONIQUES COMPORTANT DES MOYENS DE REFROIDISSEMENT

(43) Date of publication of application: 30.05.2018
(73) Proprietor: Alcatel Lucent, 91620 Nozay (FR)
(72) Inventor: GARREAU, Alexandre, 91767 PALAISEAU (FR); CASTELLANO, Andrea, 91767 PALAISEAU (FR)
(74) Representative: Novagraaf Technologies

(56) References cited:
- US-A1- 2007 117 306
- DE SAGAZAN O ET AL: "Horizontal buried channels in monocrystalline silicon", MICROSYSTEM TECHNOLOGIES ; MICRO AND NANOSYSTEMS INFORMATION STORAGE AND PROCESSING SYSTEMS, SPRINGER, BERLIN, DE, vol. 12, no. 10-11, 6 July 2006 (2006-07-06), pages 959-963, XP019429643, ISSN: 1432-1858, DOI: 10.1007/S00542-006-0177-0

## Description

### Field of the Invention

The present invention relates to semiconductor devices, such as microelectronic or optoelectronic devices including cooling means. In particular, the invention relates to a method for integrating such cooling means to such devices.

### Background

Microelectronic and optoelectronic devices become smaller and smaller, integrating more and more functionalities. Consequently, the heat flux, which must be evacuated for good performances of the devices, increases. Therefore, a high-performance cooling system is important for improving miniaturization of such devices and easing integration of new functions.

A method of cooling based on a droplet circuit located between a device and a glass is known in the art. The problem of this solution is that the device must be protected against possible chemical reactions between the droplet and the material of the device. Moreover, in case of an optoelectronic device the wetting layer, which must be added in order to obtain a good contact between the device and the droplet, can modify the optical behaviour of the device.

Document US 2007/117306 A1 discloses a method of making semiconducting device including a microfluidic cooling circuit according to the preamble of claim 1. Another method for making such a device is also disclosed in the publication "Horizontal buried channels in microcrystalline silicon", of DE SAGAZON O et al, in Microsystem Technologies, vol. 12, no 10-11, 6 July 2006, pages 959-963.

The aim of the present invention is to provide a method of cooling devices such as microelectronic or optoelectronic devices, that allows to overcome drawbacks of the methods known from the state of the art.

### Summary

In a first general embodiment, the invention relates to a method for making a microelectronic or an optoelectronic device including a substrate grown in a first semiconductor material, the method comprises integration of a microfluidic cooling circuit within the substrate.
By this way, there is no risk of chemical interaction between the active layers of the device and the cooling liquid or gas which is confined in the obtained channel and no wetting layer is needed.

On the other hand, the cooling circuit is made of the same material than the substrate. This allows to avoid the disadvantage of compatibility with other materials usually used in the field of microelectronic such as PDMS.

This also allows to enhance thermal dissipation as there is no thermal resistivity added between the device and the cooling liquid or gas, such thermal resistivity may be, for example, du to presence of a PDMS layer between the cooling circuit and the chip.

Another advantage is that the fabrication process is simplified, the cooling circuit is not added after the device process, and therefore damages risk of the device is reduced.

A further advantage of this method is that, no cover layer is needed contrary to the case where a cooling channel based only on a groove made in the back of the substrate and which is not enough to confine the cooling liquid or gas.

The integration of the microfluidic circuit within the substrate is obtained by steps of:
- Growing a second semiconductor within the substrate, said second semiconductor presenting the shape of the microfluidic circuit, and then
- Selectively etching the second semiconductor.

The second semiconductor includes at least one semiconductor layer. Therefore it may be a single layer or a multilayer semiconductor including at least two different materials and/or layers of the same material but with different doping.

In this case the process is simplified, as using of a specific etchant allows etching of the second semiconductor and obtaining the cooling circuit.

According to a first embodiment of the invention, the step of growing the second semiconductor includes sub-steps of:
a) Patterning a dielectric mask on the substrate, the mask including non-protected areas having the shape of the microfluidic circuit, and protected areas defining positions for pillars. The dielectric mask may include SiO₂, Si₃N₄ and/or SiON_{x.}
b) Etching the semiconductor substrate in the non-protected areas of the mask so as to obtain the shape of the microfluidic circuit and the pillars. The etching may be made by ICP-RIE, RIE, or IBE.
c) Growing the second semiconductor where the substrate has been etched. The growth may be made, for example, by either butt-joint or selective area growth epitaxy.
d) Removing the dielectric mask, by dry or wet etching, and then
e) Growing a capping layer of the first semiconductor material, on the second semiconductor and the pillars, so as to obtain a pseudo-substrate including the second semiconductor embedded in the first semiconductor material.

According to another embodiment of the invention, the step of growing the second semiconductor includes sub-steps of:
a') Growing the second semiconductor on the substrate, by either butt-joint or selective area growth epitaxy, for example.
b') Patterning a dielectric mask on the second semiconductor, the mask including non-protected areas defining positions for pillars and protected areas having the shape of the microfluidic circuit. The dielectric mask may include SiO₂, Si₃N₄ and/or SiONₓ.
c') Etching the second semiconductor in the non-protected areas of the mask, for example by ICP-RIE, RIE, or IBE.
d') Continue growing of the first semiconductor material where the second semiconductor has been etched, so as to obtain the shape of the microfluidic circuit and the pillars (made of the first semiconductor material). The growth is made, for example, by butt-joint or selective area growth epitaxy.
e') Removing the dielectric mask, by dry or wet etching, and then f) Growing a capping layer of the first semiconductor material, on the second semiconductor and the pillars, so as to obtain a pseudo-substrate including the second semiconductor embedded in the first semiconductor material.

Advantageously, the method further comprises steps of:
g) Growing semiconductor active layer(s) on the obtained pseudo-substrate;
h) Patterning at least a device on said semiconductor active layers and then protect the at least a device by encapsulation with a resist or a mask;
i) Etching a hole in the substrate so as to reach the second semiconductor,
j) Using a specific etchant to etch selectively the second semiconductor but not the first semiconductor material so as to obtain the microfluidic circuit inside the substrate.

Advantageously, the first semiconductor material is InP and the second semiconductor includes AlGaInAs and/or GaInAs. In this case, the specific etchant may include H2SO4, H2O2 and H2O.

Advantageously, the first semiconductor material is AIGaAs or InGaAs and the second semiconductor includes GaAs. In this case, the specific etchant may include Citric acid, H2O2 and water, or NH4OH, H2O2 and water.

Advantageously, the first semiconductor material is Silicon and the second semiconductor includes GaSb and AlGaAsSb or AlAsSb at the interface between Silicone and GaSb. In this case, the specific etchant may be HF or Buffered Oxide Etch (BOE) also known as buffered HF or BHF.

### Brief Description of the Drawings

Some embodiments of the method in accordance with the present invention are now described, by way of examples only, and with reference to the accompanying drawings, in which :
- The Figures 1a to 1e schematically illustrate steps of fabricating a semiconductor substrate including a second semiconductor inside, according to a first embodiment of the invention ;
- The Figures 2a to 2e schematically illustrate steps of fabricating a semiconductor substrate including a second semiconductor inside, according to a second embodiment of the invention ;
- The Figures 3a to 3e schematically illustrate steps of fabricating a microfluidics cooling circuit from the semiconductor substrate of figure 1e or 2e ;
- The Figures 4a to 4e schematically illustrate steps of fabricating a microfluidics cooling circuit from the semiconductor substrate of figure 1e or 2e according to another embodiment.

### Description of Embodiments

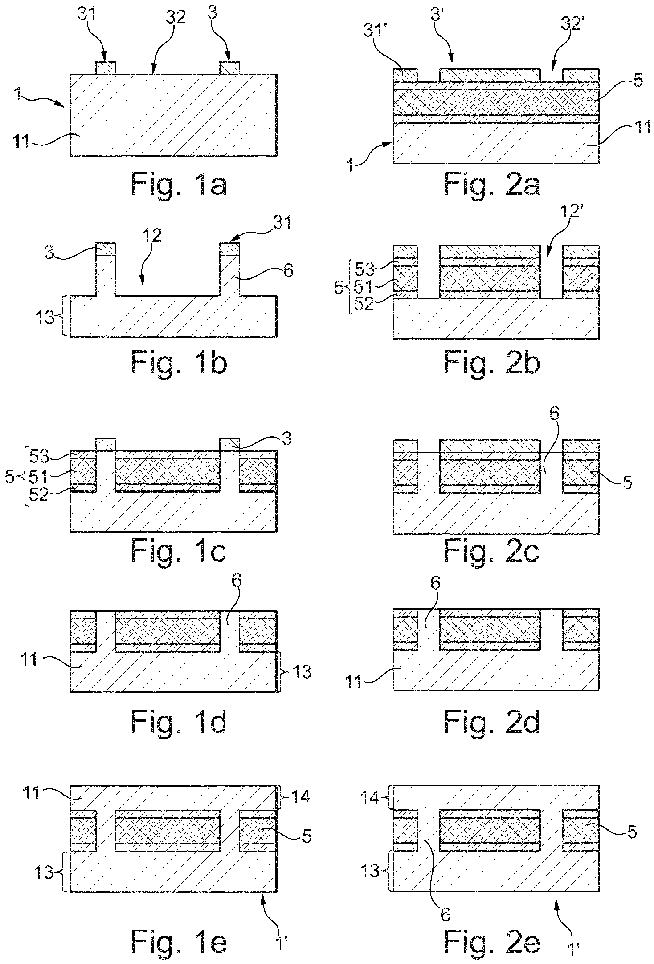

Figures 1a to 1e schematically illustrate steps of fabricating a semiconductor substrate 1 including a second semiconductor 5 inside.

Figure 1a shows an example of semiconductor substrate 1 including a first semiconductor material 11. A dielectric mask 3 is patterned on the substrate 1. The mask 3 includes non-protected areas 32 having a shape of a future microfluidic circuit (obtained after etching as will be seen later), and protected areas 31 having a shape of pillars. The dielectric mask 3 may include SiO2, Si3N4 and/or SiONx.

Figure 1b shows the substrate 1 after it has been etched in the non-protected areas 32. The etching may be made by ICP-RIE, RIE, or IBE.

The etched areas 12 has the shape of the microfluidic cooling circuit. The etched substrate also presents pillars 6 resulting in the non-etched areas 31 of the substrate.

Figure 1c illustrates the substrate 1 after a second semiconductor 5 has been grown in the etched areas 12 of the substrate 1. The growth may be made by butt-joint or selective area growth epitaxy.

Figure 1d illustrates the substrate 1 and the second semiconductor 5 after removing the dielectric mask 3.

Figure 1e illustrates the substrate 1 after a capping layer 14, for example in the same material 11 as the bottom layer 13 of the substrate 1, has been added.

Therefore, in the obtained structure the second semiconductor 5 is embedded in the first semiconductor material 11 between the bottom layer 13 and the capping layer 14.

Figures 2a to 2e illustrate steps of fabricating the semiconductor substrate 1 including the second semiconductor 5 inside according to another embodiment of the method of the invention.

In the first step illustrated in Figure 2a, the second dielectric 5 has been grown on the semiconductor substrate 1. A dielectric mask 3' is patterned on the substrate 1. The mask 3' is inversed by contrast to that of fig 1a, and includes non-protected areas 32' having a shape of pillars 6 and protected areas 31' having shape of future microfluidic circuit 2'. The dielectric mask 3 may include SiO2, Si3N4 and/or SiONx.

Figure 1b illustrates the substrate 1 and the second semiconductor 5 after said second semiconductor 5 has been etched in the non-protected areas 32'. The etching may be made by ICP-RIE, RIE, or IBE. The etched areas 12' have the shape of the pillars.

Figure 1c illustrates the substrate 1 growth of the first semiconductor material 11 has been continued where the second semiconductor 5 has been etched, so as to obtain the pillars 6 made in the first semiconductor material 11.

The growth may be made by either butt-joint or selective area growth epitaxy.

Figure 2d illustrates the substrate 1 and the second semiconductor 5 after removing the dielectric mask 3'. The structure is the same as the one obtained in figure 1d.

Figure 2e illustrate the substrate 1 after a capping layer 14, for example in the same material 11 as the bottom layer 13 of the substrate 1, has been added.

Therefore, in the obtained structure the second semiconductor 5 is embedded in the first semiconductor material 11 between the bottom layer 13 and the capping layer 14.

More precisely, the obtained substrate is a pseudo-substrate.

According to another non illustrated example, the capping layer material may be different from the material 11 of the bottom layer 13 of the substrate.

Doping of the capping layer 14 can also vary in concentration and nature (semi-insulating/p or semi-insulating/n) compared to the doping of the bottom layer 13 of the substrate 1.

The second semiconductor in the above examples contains three layers, a principal layer 51 and two other layers 52, 53 at the interface of the principal layer 51 with the bottom layer 13 and the capping layer 14 of the substrate 1.

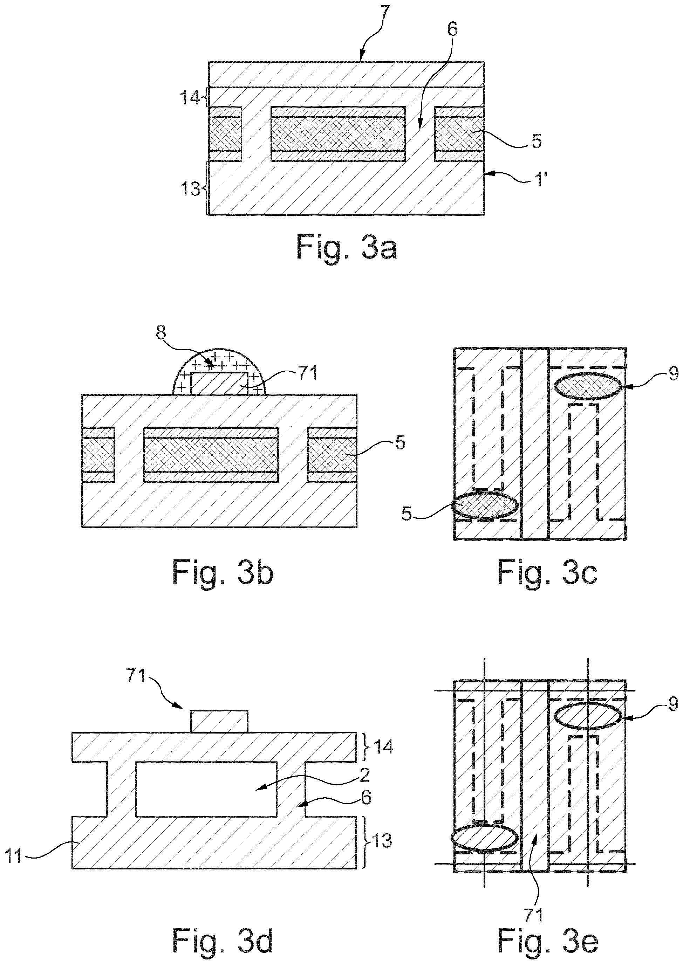

Figures 3a to 3e illustrate an example of possible further steps of making a microfluidic cooling circuit in the substrate obtained in figures 1e or 2e, in case the second semiconductor 5 has a good lattice matching with the substrate material 11.

Figure 3a illustrates the substrate 1 on which a single or multilayer 7 of semiconductor material(s) necessary for making a microelectronic or optoelectronic device have been grown, for example by epitaxy. These layers are also designated as active layers.

In figure 3b, a device 71 has been fabricated on the active layer(s) and protected by encapsulation 8. It can also be protected by a mask.

Figure 3 c illustrates the next step where a hole 9 is etched in the substrate 1 until the second semiconductor 5. The hole 9 can be etched by a chemical solution or a dry etching like ICP RIE, RIE or IBE, while the other areas being protected, for example by a mask.

And then by using a specific etchant a selective etching is carried out, wherein the second semiconductor 5 is etched but not the first semiconductor material so as to obtain the microfluidic circuit inside the substrate as shown by figures 3d and 3e.

The following table shows some examples of possible first semiconductor material, second semiconductor and specific etchant that can be used to fabricate a microelectronic or an optoelectronic device by using the method of the invention as described above.

| | | |
|---|---|---|
| Substrate material | InP | AlGaAs or InGaAs |
| Second semiconductor | AlGaInAs or GaInAs | GaAs |
| Specific Etchant | H2SO4+ H2O2+H2O | Citric acid+ H2O2+H2O or NH4OH+H2O2+H2O |

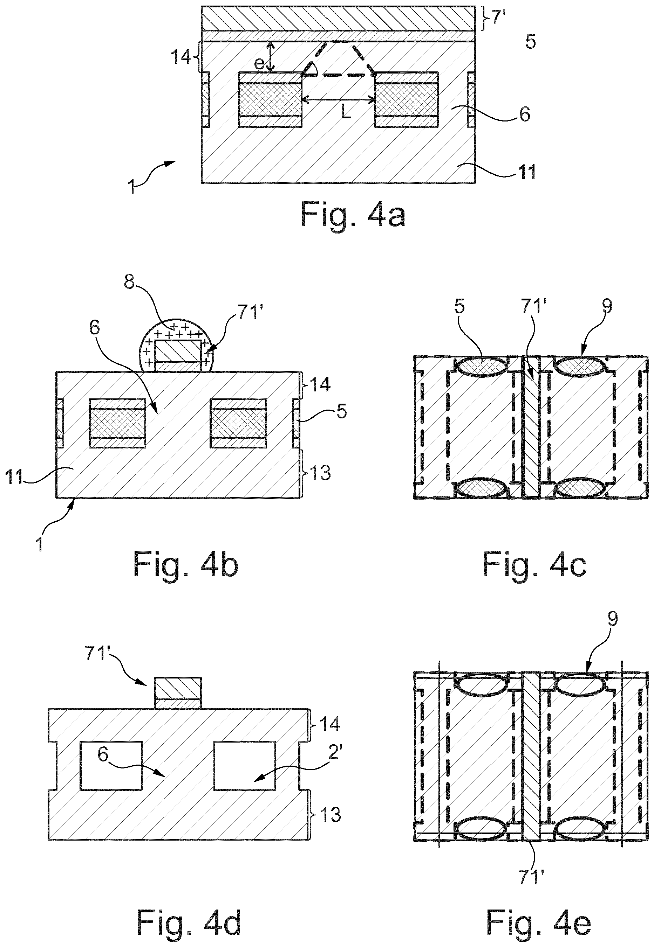

Figures 4a to 4e illustrate an example of possible further steps of making a microfluidic cooling circuit in the substrate obtained in figures 1e or 2e, in case the second semiconductor 5 has a lattice mismatching with the capping layer 14 of the substrate 1.
In this case the microelectronic or optoelectronic device is located above a pillar, because:
- above the pillars 6 realized in the same semiconductor material 11 than the bottom layer of the substrate 11, the crystallinity is without default, and
- above the second semiconductor 5, the crystallinity presents some defaults. These defaults spread in function of an angle. For example, if this angle is 45°, the maximum thickness e of the semiconductor capping layer 14 without default at the middle of the pillar is equal to L/2, where L is the width of the pillar.

Figure 4b shows a difference in width of the pillar 6 and other neighbouring pillars, however this is not necessary.

This case is particularly interesting for a silicon substrate. The semiconductor layers of the microelectronic or optoelectronic devices are different of the substrate. They are usually based on direct gap semiconductor as InP or GaSb. It is necessary to use a lattice matching layer as AlAsSb between silicon and GaSb or other materials as AlGaAsSb between silicon and InP.

After patterning the devices, a hole 9 is etched until the semiconductor layer 5 as shown in figure 4c.

By using a specific etchant (HF based solution in order to etch AlGaAsSb layers, for example), the second semiconductor is suppressed to create a microfluidic circuit 2' without degradation of the device 71' protected by encapsulation or by a mask, as shown by figures 4d and 4e.

In figures 3c, 3d, 4c and 4d the discontinuous lines indicate positions of the pillars.

The continuous lines in figures 3e and 4e indicate possible directions for cleaving to separate individual devices.

## Claims

1. A method for making a microelectronic or an optoelectronic device (7; 7') including a substrate (1) grown in a first semiconductor material (11), the method comprises an integration of a microfluidic cooling circuit (2; 2') within the substrate (1), **characterized in that** the integration of the microfluidic circuit (2; 2') within the substrate (1) is obtained by steps of:
- Growing a second semiconductor (5) within the substrate (1), said second semiconductor (5) presenting the shape of the microfluidic circuit; and then
- Selectively etching said second semiconductor (5).

2. The method according to claim 1, wherein the step of growing the second semiconductor includes sub-steps of:
a) Patterning a dielectric mask (3) on the substrate (1), the mask (3) including non-protected areas (32) having the shape of the microfluidic circuit (2), and protected areas (31) defining positions for pillars (6);
b) Etching the semiconductor substrate (1) in the non-protected areas (32) of the mask so as to obtain the shape of the microfluidic circuit (2; 2') and the pillars (6);
c) Growing the second semiconductor (5) where the substrate (1) has been etched,
d) Removing the dielectric mask (3), and then
e) Growing a capping layer (14) of the first semiconductor material (11), on the second semiconductor (5) and the pillars (6), so as to obtain a pseudo-substrate (1') including the second semiconductor (5) embedded in the first semiconductor material (11).

3. The method according to claim 1, wherein the step of growing the second semiconductor includes sub-steps of:
a') Growing the second semiconductor (5) on the substrate (1);
b') Patterning a dielectric mask (3') on the second semiconductor (5), the mask (3') including non-protected areas (32') defining positions for pillars, and protected areas (31') having the shape of the microfluidic circuit (2; 2');
c') Etching the second semiconductor (5) in the non-protected areas (32') of the mask (3');
d') Continue growing of the first semiconductor material (11) where the second semiconductor has been etched, so as to obtain the shape of the microfluidic circuit (2; 2') and pillars (6);
e') Removing the dielectric mask (3'); and then f') Growing a capping layer (14) of the first semiconductor material (11), on the second semiconductor (5) and the pillars (6), so as to obtain a pseudo-substrate (1') including the second semiconductor (5) embedded in the first semiconductor material (11).

4. The method according to any of claims 2 or 3, further comprising steps of:
g) Growing semiconductor active layer(s) (7; 7') on the obtained pseudo-substrate (1');
h) Patterning at least a device (71, 71') on said semiconductor active layer(s) (7; 7') and then protect it by encapsulation with a resist (8) or a mask;
i) Etching a hole (9) in the substrate (1) so as to reach the second semiconductor (5);
j) Using a specific etchant to etch selectively the second semiconductor (5) but not the first semiconductor material (11) so as to obtain the microfluidic circuit (2; 2') inside the substrate (1);

5. The method according to anyone of claims 1 to 4, wherein the first semiconductor material (11) is InP and the second semiconductor includes AlGaInAs and/or GaInAs.

6. The method according to claim 5 depending in claim 4, wherein the specific etchant includes H2SO4, H2O2 and H2O.

7. The method according to anyone of claims 1 to 4, wherein the first semiconductor material (11) is AIGaAs or InGaAs and the second semiconductor includes GaAs.

8. The method according to claim 7 depending on claim 4, wherein the specific etchant includes Citric acid, H2O2 and water or NH4OH, H2O2 and water.

9. The method according to anyone of claims 1 to 4, wherein the first semiconductor material (11) is Silicon and the second semiconductor (5) includes GaSb and AlGaAsSb or AlAsSb at the interface between Silicon and GaSb.

10. The method according to claim 9, wherein the specific etchant includes HF or BHF.

## Patentansprüche

1. Verfahren zum Herstellen einer mikroelektronischen oder einer optoelektronischen Vorrichtung (7; 7'), enthaltend ein Substrat (1), das in einem ersten Halbleitermaterial (11) gezüchtet wird, wobei das Verfahren ein Integrieren eines mikrofluiden Kühlkreislaufs (2; 2') in dem Substrat (1) umfasst; **dadurch gekennzeichnet, dass** das Integrieren des mikrofluiden Kühlkreislaufs (2; 2') in dem Substrat (1) durch folgende Schritte erhalten wird:
- Züchten eines zweiten Halbleiters (5) in dem Substrat (1), wobei der zweite Halbleiter (5) die Form des mikrofluiden Kreislaufs aufweist; und dann
- selektives Ätzen des zweiten Halbleiters (5).

2. Verfahren nach Anspruch 1, wobei der Schritt zum Züchten des zweiten Halbleiters Teilschritte enthält zum:
a) Strukturieren einer dielektrischen Maske (3) auf dem Substrat (1), wobei die Maske (3) ungeschützte Flächen (32) mit der Form des mikrofluiden Kreislaufs (2), und geschützte Flächen (31), die Positionen für Säulen (6) definieren, enthält;
b) Ätzen des Halbleitersubstrats (1) in den ungeschützten Flächen (32) der Maske, um so die Form des mikrofluiden Kreislaufs (2, 2') und der Säulen (6) zu erhalten;
c) Züchten des zweiten Halbleiters (5), wo das Substrat (1) geätzt wurde,
d) Entfernen der dielektrischen Maske (3) und dann
e) Züchten einer Kappenschicht (14) des ersten Halbleitermaterials (11) auf dem zweiten Halbleiter (5) und den Säulen (6), um so ein Pseudo-Substrat (1') zu erhalten, das den zweiten Halbleiter (5) eingebettet in dem ersten Halbleitermaterial (11) enthält.

3. Verfahren nach Anspruch 1, wobei der Schritt zum Züchten des zweiten Halbleiters Teilschritte enthält zum:
a') Züchten des zweiten Halbleiters (5) auf dem Substrat (1);
b') Strukturieren einer dielektrischen Maske (3') auf dem zweiten Halbleiter (5), wobei die Maske (3') ungeschützte Flächen (32'), die Positionen für Säulen definieren, und geschützte Flächen (31') mit der Form des mikrofluiden Kreislaufs (2; 2') enthält;
c') Ätzen des zweiten Halbleiters (5) in den ungeschützten Flächen (32') der Maske (3');
d') Fortsetzen eines Züchtens des ersten Halbleitermaterials (11) wo der zweite Halbleiter geätzt wurde, um so die Form des mikrofluiden Kreislaufs (2; 2') und der Säulen (6) zu erhalten;
e') Entfernen der dielektrischen Maske (3') und dann
f') Züchten einer Kappenschicht (14) des ersten Halbleitermaterials (11) auf dem zweiten Halbleiter (5) und den Säulen (6), um so ein Pseudo-Substrat (1') zu erhalten, das den zweiten Halbleiter (5) eingebettet in dem ersten Halbleitermaterial (11) enthält.

4. Verfahren nach einem der Ansprüche 2 oder 3, ferner aufweisend Schritte zum:
g) Züchten aktiver Halbleiterschicht(en) (7; 7') auf dem erhaltenen Pseudo-Substrat (1');
h) Strukturieren mindestens einer Vorrichtung (71, 71') auf der (den) aktiven Halbleiterschicht(en) (7; 7') und dann Schützen derselben durch Einkapselung mit einem Fotolack (8) oder einer Maske;
i) Ätzen eines Lochs (9) in das Substrat (1), um den zweiten Halbleiter (5) zu erreichen;
j) Verwenden eines speziellen Ätzmittels, um den zweiten Halbleiter (5), nicht aber das erste Halbleitermaterial (11) selektiv zu ätzen, um so den mikrofluiden Kreislauf (2; 2') im Inneren des Substrats (1) zu erhalten.

5. Verfahren nach einem der Ansprüche 1 bis 4, wobei das erste Halbleitermaterial (11) InP ist und der zweite Halbleiter AlGaInAs und/oder GaInAs enthält.

6. Verfahren nach Anspruch 5, abhängig von Anspruch 4, wobei das spezielle Ätzmittel H2SO4, H2O2 und H2O enthält.

7. Verfahren nach einem der Ansprüche 1 bis 4, wobei das erste Halbleitermaterial (11) AlGaAs oder InGaAs ist und der zweite Halbleiter GaAs enthält.

8. Verfahren nach Anspruch 7, abhängig von Anspruch 4, wobei das spezifische Ätzmittel Zitronensäure, H2O2 und Wasser oder NH4OH, H2O2 und Wasser enthält.

9. Verfahren nach einem der Ansprüche 1 bis 4, wobei das erste Halbleitermaterial (11) Silizium ist und der zweite Halbleiter (5) GaSb und AlGaAsSb oder AlAsSb an der Grenzfläche zwischen Silizium und GaSb enthält.

10. Verfahren nach Anspruch 9, wobei das spezielle Ätzmittel HF oder BHF aufweist.

## Revendications

1. Procédé de fabrication d'un dispositif microélectronique ou optoélectronique (7 ; 7') comportant un substrat (1) élaboré dans un premier matériau semi-conducteur (11), le procédé comprenant l'intégration d'un circuit de refroidissement microfluidique (2 ; 2') à l'intérieur du substrat (1), **caractérisé en ce que**
l'intégration du circuit microfluidique (2 ; 2') à l'intérieur du substrat (1) est obtenue par des étapes consistant à :
- élaborer un deuxième semi-conducteur (5) à l'intérieur du substrat (1), ledit deuxième semi-conducteur (5) présentant la forme du circuit microfluidique ; et ensuite
- graver sélectivement ledit deuxième semi-conducteur (5).

2. Procédé selon la revendication 1, dans lequel l'étape d'élaboration du deuxième semi-conducteur comporte des sous-étapes consistant à :
a) modeler un masque diélectrique (3) sur le substrat (1), le masque (3) comportant des zones non protégées (32) ayant la forme du circuit microfluidique (2), et des zones protégées (31) définissant des positions pour des piliers (6) ;
b) graver le substrat semi-conducteur (1) dans les zones non protégées (32) du masque de manière à obtenir la forme du circuit microfluidique (2 ; 2') et les piliers (6) ;
c) élaborer le deuxième semi-conducteur (5) là où le substrat (1) a été gravé ;
d) retirer le masque diélectrique (3) ; et ensuite
e) élaborer une couche d'encapsulation (14) du premier matériau semi-conducteur (11), sur le deuxième semi-conducteur (5) et les piliers (6), de manière à obtenir un pseudo-substrat (1') comportant le deuxième semi-conducteur (5) incorporé dans le premier matériau semi-conducteur (11).

3. Procédé selon la revendication 1, dans lequel l'étape d'élaboration du deuxième semi-conducteur comporte des sous-étapes consistant à :
a') élaborer le deuxième semi-conducteur (5) sur le substrat (1) ;
b') modeler un masque diélectrique (3') sur le deuxième semi-conducteur (5), le masque (3') comportant des zones non protégées (32') définissant des positions pour des piliers, et des zones protégées (31') ayant la forme du circuit microfluidique (2 ; 2') ;
c') graver le deuxième semi-conducteur (5) dans les zones non protégées (32') du masque (3') ;
d') poursuivre l'élaboration du premier matériau semi-conducteur (11) là où le deuxième semi-conducteur a été gravé, de manière à obtenir la forme du circuit microfluidique (2 ; 2') et les piliers (6) ;
e') retirer le masque diélectrique (3') ; et ensuite
f') élaborer une couche d'encapsulation (14) du premier matériau semi-conducteur (11), sur le deuxième semi-conducteur (5) et les piliers (6), de manière à obtenir un pseudo-substrat (1') comportant le deuxième semi-conducteur (5) incorporé dans le premier matériau semi-conducteur (11).

4. Procédé selon l'une quelconque des revendications 2 ou 3, comprenant en outre des étapes consistant à :
g) élaborer une/des couche(s) semi-conductrice(s) active(s) (7 ; 7') sur le pseudo-substrat (1') obtenu ;
h) modeler au moins un dispositif (71, 71') sur ladite/lesdites couche(s) semi-conductrice(s) active(s) (7 ; 7') et le protéger ensuite par encapsulation avec une réserve de gravure (8) ou un masque ;
i) graver un trou (9) dans le substrat (1) de manière à atteindre le deuxième semi-conducteur (5) ;
j) utiliser un agent de gravure spécifique pour graver sélectivement le deuxième semi-conducteur (5), mais pas le premier matériau semi-conducteur (11), de manière à obtenir le circuit microfluidique (2 ; 2') à l'intérieur du substrat (1).

5. Procédé selon l'une quelconque des revendications 1 à 4, dans lequel le premier matériau semi-conducteur (11) est l'InP et le deuxième semi-conducteur comporte de l'AlGaInAs et/ou du GaInAs.

6. Procédé selon la revendication 5 dépendante de la revendication 4, dans lequel l'agent de gravure spécifique comporte H2SO4, H2O2 ou H2O.

7. Procédé selon l'une quelconque des revendications 1 à 4, dans lequel le premier matériau semi-conducteur (11) est l'AlGaAs ou l'InGaAs et le deuxième semi-conducteur comporte du GaAs.

8. Procédé selon la revendication 7 dépendante de la revendication 4, dans lequel l'agent de gravure spécifique comporte de l'acide citrique, H2O2 et de l'eau ou NH40H, H2O2 et de l'eau.

9. Procédé selon l'une quelconque des revendications 1 à 4, dans lequel le premier matériau semi-conducteur (11) est le silicium et le deuxième semi-conducteur (5) comporte du GaSb et de l'AlGaAsSb ou de l'AlAsSb à l'interface entre le silicium et le GaSb.

10. Procédé selon la revendication 9, dans lequel l'agent de gravure spécifique comporte HF ou BHF.
